# EUROPEAN PATENT APPLICATION

(11) **EP 1 981 095 A2**
(43) Date of publication of application: **15.10.2008**
(21) Application number: 07116950.2
(22) Date of filing: 21.09.2007
(51) Int. Cl.: H01L 35/32

(54) **A peltier module**

(30) Priority: 14.04.2007 DE 102007017712
(71) Applicant: Deutsches Zentrum für Luft- und Raumfahrt e.V., 51147 Köln (DE); Angaris GmbH, 06120 Halle/Saale (DE); Labor S.r.l., 00186 Roma (RM) (IT)
(72) Inventor: Platzek, Dieter, 56218 Mülheim-Kärlich (DE); Müller, Eckhard, 53229 Bonn (DE); Engers, Bernd, 06108 Halle (DE); Morea, Fabio, I-34074 Monfalcone (GO) (IT)
(74) Representative: Selting, Günther

(57) **Abstract**

A Peltier module comprises a first substrate (10) and a second substrate (11). Legs (14) of thermoelectric material are located between them. The ends of the legs (14) are coated with a barrier layer (17,18) over which an electric conductor layer (12,13) is located which is connected with the respective substrate (10,11). The substrates (10,11) are flexible and have a thickness of 40 µ at maximum. Outside, they are coated with a heat conducting layer (19,20). The legs (14) have a length of between 50 and 300 µ and the barrier layers (17,18) have a thickness of 5 µ at maximum. Thereby, a high coefficient of performance (COP) is made possible.

## Description

The invention relates to a Peltier module comprising two mutually spaced substrates having column-like legs of thermoelectric material located between them.

Peltier devices are plate-like structures flown through by a d.c. current and then providing a cooling effect at the one side and a heating effect at the opposite side. The legs consist of thermoelectric material, particularly of bismuth telluride based alloys of the semiconductor type. N-type legs and p-type legs are arranged in parallel and connected by conductor paths in a meandering manner. A cooling effect is generated at the one surface of the Peltier module, and a heating effect is generated at the opposite surface. The cooling side and the heating side are formed in dependence on the flux direction of the current flowing through the legs. By reversing the flux direction, the heating side and the cooling side can be interchanged.

The common Peltier modules have two parallel substrates of ceramic material. The substrates are coated with electrically conductive paths to which the thermoelectric legs are soldered. The thermoelectric legs are produced by sawing a wafer.

These production methods of the Peltier modules make it difficult to reduce the module thickness. The reason is that the ceramic substrate layers must have a certain minimum thickness and that the legs extending between the substrates must have a certain minimum length due to production requirements. The common Peltier modules are rigid plates brought in surface contact with heat sink devices , e.g., metal plates, which drain the heat of a heat source. The great thickness of the Peltier modules results in a high electric resistance with the consequence that the maximum current is low. A cooling or heating system formed by employing Peltier devices only has a good coefficient of performance COP if the electric current flowing through such a module is low in comparison with the maximum current. A high maximum current can only be achieved with a low electric resistance and consequently with a small thickness of the module. Because of the plate material used for conventional modules, it is not possible to reduce the module thickness straight away.

It is an object of the invention to provide a Peltier module providing a good coefficient of performance and being able to be mounted to any heat sink devices without any problems.

The Peltier module according to the invention is defined by claim 1. In this module, the substrates between which the legs are located are flexible films capable of adapting themselves to an uneven contour of a base surface.

Such a module has the advantage to be adapted to be mounted to buildings or other uneven heat sink surfaces without any problems in order to achieve a cooling or heating effect in buildings or other structures. Generally, the flexible Peltier module can be mounted to different structures without the requirement of the base surface being even. Because of the flexibility of the Peltier module, an all-over contact with the respective base surface or heat sink device is made. This means that the Peltier module has a good adaptability to different topographies. This causes a good heat transmission.

Preferably, the Peltier module according to the invention is configured such that the crossplane legs have a length of between 50 and 300 µm and the barrier layer has a thickness of 5 µm at maximum. The barrier layer is necessary to avoid a direct contact of the conductor layer with the thermoelectric material. Otherwise, a conductor layer consisting of copper would diffuse into the thermoelectric material, e.g., a bismuth telluride alloy. A barrier layer consisting of, e.g., Ni or Mo, prevents such a diffusion but has the disadvantage of a relatively high contact resistance. This means that the resistance of the barrier layer substantially influences the total resistance of the series connection of thermoelectric legs and barrier layer. Thereby, the resistance losses are increased and the coefficient of performance of the Peltier module is reduced. Due to the fact that the leg length is substantially greater than the thickness of the barrier layer, the influence of the barrier layer on the total resistance is reduced. On the other hand, the length of the thermoelectric legs is remarkably reduced compared with the known Peltier structures so that a high maximum current becomes possible.

The power density of the Peltier module varies in correspondence with the thickness of the module. To achieve an efficient cooling, the density value has to be chosen such that an economic operation of the thermoelectric device is made possible. The optimum current density in a crossplane arrangement increases with decreasing film thickness and the Peltier heat flux also increases proportionally. The integration of thermoelectric thin film devices into microsystems focuses on achieving the highest possible cooling power density over very small areas (micro-regions). Thus, the Peltier module can be employed, for example, to effect a cooling of a small semiconductor structure which is restricted as to its area.

The thick film structure according to the invention is also suitable for the employment with devices covering large areas and operating at small to moderate temperature differences. Devices based on thick films offer technological advantages in comparison with the conventional rigid module technique.

To drain the heat or cold off the Peltier module, there is a heat conducting layer at the Peltier module at the outside of the first and/or second substrate facing away from the legs. This may be, e.g., a copper layer preferably provided continuously over the entire outer surface.

Further, the invention relates to a method for manufacturing a Peltier module, comprising the steps of:
- providing a flexible first substrate and a flexible second substrate made of a polyimide film,
- image-wise coating of each substrate with a first conductor layer,
- image-wise coating of the first conductor layer with a first barrier layer,
- producing legs of thermoelectric material on the barrier layer by
   ■ magnetron sputtering or
   ■ electrochemical deposition or
   ■ deposition of paste.

The method according to the invention can be called thick film technique where the thermoelectric legs are produced on a substrate. Thereby, the electric resistance of the legs is also reduced compared with the conventional technique and a higher COP is achieved.

Finally, less material is used so that the material costs are reduced. Since the production is effected by a standard technique, it is cheaper than with conventional Peltier modules.

Hereinafter, an embodiment of the invention is explained in detail with reference to the drawings.

In the Figures:
- Fig. 1: is a longitudinal section of a Peltier module,
- Fig. 2: is a perspective representation of a portion of the Peltier module,
- Fig. 3: is an illustration of the individual layers of the Peltier module, and
- Fig. 4: is a diagram for the explanation of the coefficient of performance (COP) as a function of current with the generation of different temperature differences.

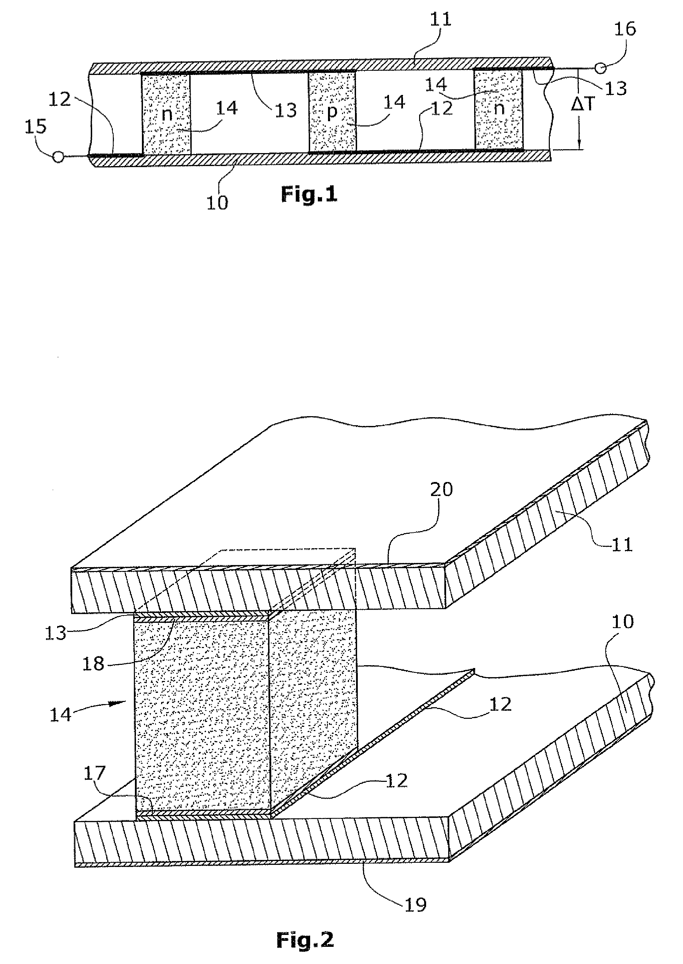

According to Figure 1, the Peltier module according to the invention comprises a first substrate 10 and a second substrate 11 spaced therefrom. The substrates are films with a thickness of 40 µm at maximum. Typical layer thicknesses are in the range of between 20 and 30 µm, particularly 25 µm.

At the inside, the first substrate 10 is covered with an image-wise first conductor layer 12 and the second substrate 11 is covered with an image-wise second conductor layer 13. The conductor layers 12 and 13 are applied onto the substrate by means of photoetching, for example, similar to the conductor paths of a printed circuit.

The substrates 10 and 11 consist of Kapton®, a material which is a polyimide that is resistant against temperatures up to over 400 °C. Because of their low heat conductivity of only about 0.13 W/mK, these polyimide foils are well suited as substrates for thermoelectric devices. Another important characteristic of the polyimide foils is their thermal expansion coefficient which is in the same order of magnitude as that of thermoelectric materials of the bismuth telluride type which is about 20 x 10⁻⁶K⁻¹ so that the thermomechanical stress of the substrates is minimized.

Column-like legs 14 forming the thermoelectric elements extend between the substrates 10,11. The legs 14 consist of an alloy on the basis of bismuth telluride. They are semiconductors, n-type legs and p-type legs alternating with each other. The legs 14 have a length in the range of between 50 to 300 µm, preferably in the range of 50 to 100 µm and particularly of about 100 µm. The one end of a leg is connected with the first conductor layer 12 in an electrically conducting manner and the opposite end is connected with the second conductor layer 13 in an electrically conducting manner. As is illustrated in Figure 1, this results in a current path from the first conductor layer 12 through a leg 14 to the second conductor layer 13 and from there via another leg 14 to the first conductor layer 12 again. This means that the current path is meandering, the legs of the n-type and the p-type being alternately flown through in series connection. The first conductor layer 12 is connected with a connecting terminal 15 and the second conductor layer 13 is connected with a connecting terminal 16. A d.c. voltage can be applied to the connecting terminals 15,16. Hence, the legs 14 arranged in a row are connected in series, neighboring legs being flown through by the current in opposite direction with respect to each other.

Depending on the polarity of the connecting terminals 15,16, a cooling is generated at the one substrate 10 and a heating at the other substrate 11. The temperature difference created thereby is called ΔT.

The Peltier module according to the invention can also be used to produce current from a temperature difference.

The first conductor layer 12 is covered by a first barrier layer 17 of nickel and the second conductor layer 13 is covered by a second barrier layer 18 of nickel. The barrier layers 17 and 18 are in direct electric surface contact with the end sides of the legs 14. The barrier layers 17 and 18 prevent the copper of the conductor layers from diffusing into the legs 14. Each of the conductor layers 12,13 has a thickness of about 30 - 200 µm. The barrier layers 17,18 have a thickness of about 2 - 3 µm each.

By means of the connecting terminals 15 and 16, the Peltier module is connected to a power source. Then, a temperature difference ΔT is created between the substrates 10,11 (Figure 1). For draining the heat or cold off the Peltier module, the outsides of the substrates 10,11 are provided with heat-conducting layers 19 and 20, respectively.

The manufacture of the Peltier module can be effected in different manners. The following three methods have been tested successfully:
1. Thermoelectric thick films were deposited according to the PVD method by magnetron sputtering on Kapton®-foils.
2. Thermoelectric thick films were applied by electrochemical deposition.
3. Thermoelectric thick films were deposited by paste technology.

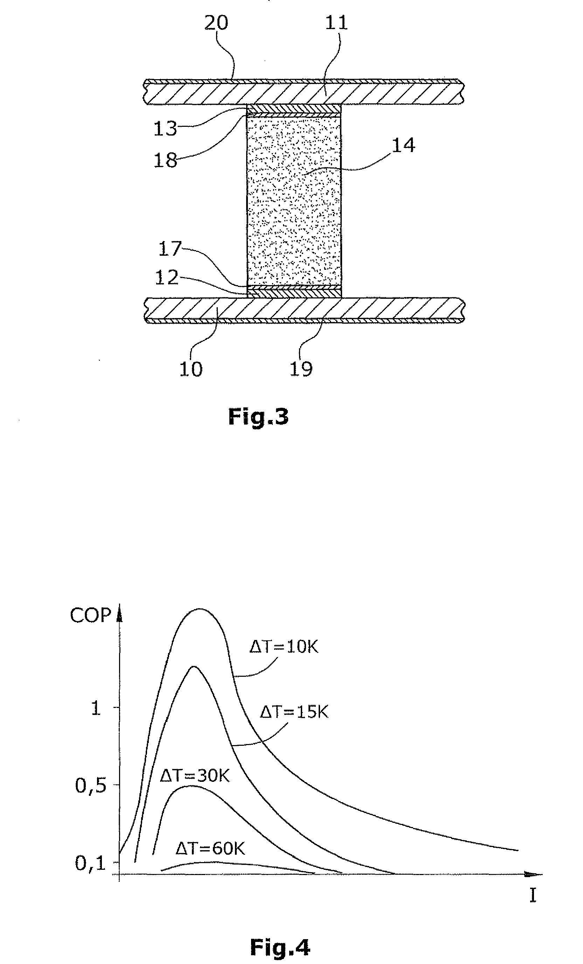

Figure 4 shows a diagram of the coefficient of performance COP, plotted over the current intensity I for different temperature differences ΔT. The lower curve with ΔT = 60 K results in a COP value of 0.1. This results from the fact that a thermal output of 10 W corresponds to an electric output of 100 W. It can be recognized that the COP is greater for the remaining temperature difference curves and may even adopt values which are greater than 1. For the COP at a certain current intensity I, there is one optimum, respectively. The high value range of COP for the respectively set temperature difference ΔT is made possible by the leg length between 50 and 30 µm and a thickness of the barrier layer of 5 µm at maximum.

## Claims

1. A Peltier module comprising a first substrate (10), a second substrate (11) arranged in parallel and at a distance to the first substrate, a first conductor layer (12) on the first substrate (10), a second conductor layer (13) on the second substrate (11), a first barrier layer (17) on the first conductor layer (12), a second barrier layer (18) on the second conductor layer (13) and comprising legs (14) of thermoelectric material arranged between the barrier layers (17,18) in conducting contact therewith, the substrates (10,11) being flexible foils adapting to an uneven contour of a base surface.

2. The Peltier module according to claim 1, **characterized in that** the legs (14) have a length of between 50 and 300 µm and the barrier layers (17,18) have a thickness of 5 µm at maximum.

3. The Peltier module according to claim 1 or 2, **characterized in that** the substrates (11) consist of a polyimide foil having a thickness of 40 µm at maximum.

4. The Peltier module according to one of claims 1 - 3, **characterized in that** the length of the legs (14) amounts to between 50 and 150 µm.

5. The Peltier module according to one of claims 1-4, **characterized in that** the length of the legs amounts to between 100 and 200 µm.

6. The Peltier module according to one of claims 1 - 5, **characterized in that** a heat conducting layer (19,20) is located at the outside of the first and/or second substrate (10,11) facing away from the legs (14).

7. A method for manufacturing a Peltier module, comprising the steps of:
- providing a flexible first substrate (10) and a flexible second substrate (11) of a polyimide foil,
- image-wise coating of each substrate with a conductor layer (12,13),
- image-wise coating of the conductor layer (12,13) with a barrier layer (17,18),
- creating legs (14) of thermoelectric material on the barrier layer (17,18) by
o magnetron sputtering or
o electrochemical deposition or
o deposition of paste
